# EUROPEAN PATENT APPLICATION

(11) **EP 2 439 790 A1**
(43) Date of publication of application: **11.04.2012**
(21) Application number: 10783403.8
(22) Date of filing: 02.06.2010
(51) Int. Cl.: H01L 31/10

(54) **SEMICONDUCTOR LIGHT DETECTING ELEMENT AND MANUFACTURING METHOD THEREFOR**

(30) Priority: 05.06.2009 JP 2009136387
(71) Applicant: Hamamatsu Photonics K.K., Hamamatsu-shi, Shizuoka 435-8558 (JP)
(72) Inventor: ISHIKAWA Yoshitaka, Hamamatsu-shi Shizuoka 435-8558 (JP); SAKAMOTO Akira, Hamamatsu-shi Shizuoka 435-8558 (JP); YAMAMURA Kazuhisa, Hamamatsu-shi Shizuoka 435-8558 (JP); KAWAISatoshi, Hamamatsu-shi Shizuoka 435-8558 (JP)
(74) Representative: HOFFMANN EITLE
(86) International application number: PCT/JP2010/059353
(87) International publication number: WO 2010/140621

(57) **Abstract**

A photodiode PD1 is provided with an n⁻ type semiconductor substrate 1 with a pn junction formed of a first conductivity type semiconductor region and a second conductivity type semiconductor region. For the n⁻ type semiconductor substrate 1, an accumulation layer 7 is formed on the second principal surface 1b side of the n⁻ type semiconductor substrate 1 and an irregular asperity 10 is formed at least in regions opposed to the pn junction in a first principal surface 1a and in the second principal surface 1b. The regions opposed to the pn junction in the first principal surface 1a and in the second principal surface 1b of the n⁻ type semiconductor substrate 1 are optically exposed.

## Description

### Technical Field

The present invention relates to a semiconductor light detecting element and a manufacturing method for the semiconductor light detecting element.

### Background Art

A photodiode using compound semiconductors is known as a semiconductor light detecting element having a high spectral sensitivity characteristic in the near-infrared wavelength band (e.g., cf. Patent Literature 1). The photodiode described in Patent Literature 1 is provided with a first light receiving layer comprised of any one of InGaAsN, InGaAsNSb, and InGaAsNP, and a second light receiving layer having an absorption edge of a longer wavelength than that of the first light receiving layer and comprised of a quantum well structure.

### Citation List

### Patent Literature

Patent Literature 1: Japanese Patent Application Laid-open No. 2008-153311

### Summary of Invention

### Technical Problem

However, the photodiode using compound semiconductors as described above is still expensive and requires complicated manufacturing steps. For this reason, there are demands for practical utilization of a silicon photodiode being inexpensive and easy to manufacture, having sufficient spectral sensitivity in the near-infrared wavelength band. The conventional silicon photodiodes generally had the limit of about 1100 nm on the long wavelength side of the spectral sensitivity characteristic but the spectral sensitivity characteristic in the wavelength band of not less than 1000 nm was not enough.

It is an object of the present invention to provide a semiconductor light detecting element using silicon and having a sufficient spectral sensitivity characteristic in the near-infrared wavelength band, and a method for manufacturing the semiconductor light detecting element.

### Solution to Problem

A semiconductor light detecting element according to the present invention is one comprising: a silicon substrate having a pn junction formed of a semiconductor region of a first conductivity type and a semiconductor region of a second conductivity type, wherein for the silicon substrate, an accumulation layer of the first conductivity type is formed on one principal surface side of the silicon substrate and an irregular asperity is formed at least in regions opposed to the pn junction in the one principal surface and in a principal surface opposed to the one principal surface, and wherein the regions opposed to the pn junction in the one principal surface of the silicon substrate and in the principal surface thereof opposed to the one principal surface are optically exposed.

In the semiconductor light detecting element according to the present invention, the irregular asperity is formed at least in the regions opposed to the pn junction in the one principal surface and in the principal surface opposed to the one principal surface. For this reason, light incident into the semiconductor light detecting element is reflected, scattered, or diffused by the regions to travel through a long distance in the silicon substrate. This makes the light incident into the semiconductor light detecting element mostly absorbed in the silicon substrate, without passing through the semiconductor light detecting element (silicon substrate). According to the present invention, therefore, the light incident into the semiconductor light detecting element has the long travel distance and the distance of absorption of light also becomes long, so as to improve the spectral sensitivity characteristic in the near-infrared wavelength band.

In the semiconductor light detecting element according to the present invention, the accumulation layer of the first conductivity type is formed on the one principal surface side of the silicon substrate. For this reason, unnecessary carriers generated irrespective of light on the one principal surface side are recombined, so as to reduce dark current. The accumulation layer prevents carriers generated by light near the one principal surface of the silicon substrate, from being trapped in the one principal surface. For this reason, the carriers generated by light efficiently migrate to the pn junction, so as to improve the light detection sensitivity of the semiconductor light detecting element.

Another semiconductor light detecting element according to the present invention is one comprising: a silicon substrate comprised of a semiconductor of a first conductivity type, having a first principal surface and a second principal surface opposed to each other, and having a semiconductor region of a second conductivity type formed on the first principal surface side, wherein for the silicon substrate, an accumulation layer of the first conductivity type having an impurity concentration higher than that of the silicon substrate is formed on the second principal surface side and an irregular asperity is formed at least in regions opposed to the semiconductor region of the second conductivity type in the first principal surface and in the second principal surface, and wherein the regions opposed to the semiconductor region of the second conductivity type in the first principal surface and in the second principal surface of the silicon substrate are optically exposed.

In the semiconductor light detecting element according to the present invention, the irregular asperity is formed at least in the regions opposed to the pn junction in the first principal surface and in the second principal surface. For this reason, light incident into the semiconductor light detecting element is reflected, scattered, or diffused by the regions to travel through a long distance in the silicon substrate. This makes the light incident into the semiconductor light detecting element mostly absorbed in the silicon substrate, without passing through the semiconductor light detecting element (silicon substrate). According to the present invention, therefore, the light incident into the semiconductor light detecting element has the long travel distance and the distance of absorption of light also becomes long, so as to improve the spectral sensitivity characteristic in the near-infrared wavelength band.

In the semiconductor light detecting element according to the present invention, the accumulation layer of the first conductivity type is formed on the second principal surface side of the silicon substrate. For this reason, unnecessary carriers generated irrespective of light on the second principal surface side are recombined, so as to reduce dark current. The accumulation layer prevents carriers generated by light near the second principal su-rface of the silicon substrate, from being trapped in the second principal surface. For this reason, the carriers generated by light efficiently migrate to the pn junction between the second conductivity type semiconductor region and the silicon substrate, so as to improve the light detection sensitivity of the semiconductor light detecting element.

The thickness of the accumulation layer may be larger than a height difference of the irregular asperity. In this case, the operational effect by the accumulation layer can be ensured as described above.

A manufacturing method for a semiconductor light detecting element according to the present invention is a method for manufacturing a semiconductor light detecting element, comprising: a step of preparing a silicon substrate having a pn junction formed of a semiconductor region of a first conductivity type and a semiconductor region of a second conductivity type; a step of forming an accumulation layer of the first conductivity type on one principal surface side of the silicon substrate; a step of irradiating at least regions opposed to the pn junction in the one principal surface of the silicon substrate and in a principal surface thereof opposed to the one principal surface, with a pulsed laser beam to form an irregular asperity; and a step of thermally treating the silicon substrate in which the irregular asperity is formed.

By the manufacturing method for the semiconductor light detecting element according to the present invention, the semiconductor light detecting element can be obtained as one in which the irregular asperity is formed at least in the regions opposed to the pn junction in the one principal surface and in the principal surface opposed to the one principal surface. In this semiconductor light detecting element, as described above, the light incident into the semiconductor light detecting element has the long travel distance and the distance of absorption of light also becomes long, so as to improve the spectral sensitivity characteristic in the near-infrared wavelength band. The accumulation layer formed on the one principal surface side of the silicon substrate can reduce dark current and improve the light detection sensitivity of the semiconductor light detecting element.

Incidentally, the irradiation with the pulsed laser beam could cause damage such as crystal defects of the silicon substrate. Since the present invention comprises the thermal treatment of the silicon substrate after the step of forming the irregular asperity, the crystallinity of the silicon substrate recovers, so as to prevent the problem such as increase in dark current.

The manufacturing method for the semiconductor light detecting element according to the present invention may be configured as follows: the step of preparing the silicon substrate comprises preparing a silicon substrate in which a semiconductor region of the first conductivity type having an impurity concentration higher than that of the silicon substrate is further formed on the principal surface side opposed to the one principal surface, as the silicon substrate; the manufacturing method further comprises a step of forming an electrode electrically connected to the semiconductor region of the first conductivity type and an electrode electrically connected to the pn junction, after the step of thermally treating the silicon substrate. In this case, the electrodes are prevented from melting during the step of the thermal treatment even if the electrodes are made of a material having a relatively low melting point. For this reason, the electrodes can be appropriately formed without being affected by the thermal treatment.

Another manufacturing method for a semiconductor light detecting element according to the present invention is a method for manufacturing a semiconductor light detecting element, comprising: a step of preparing a silicon substrate comprised of a semiconductor of a first conductivity type, having a first principal surface and a second principal surface opposed to each other, and having a semiconductor region of a second conductivity type formed on the first principal surface side; a step of forming an accumulation layer of the first conductivity type having an impurity concentration higher than that of the silicon substrate, on the second principal surface side of the silicon substrate; a step of irradiating at least regions opposed to the semiconductor region of the second conductivity type in the second principal surface of the silicon substrate, with a pulsed laser beam to form an irregular asperity; and a step of thermally treating the silicon substrate, after the step of forming the irregular asperity.

By the manufacturing method for the semiconductor light detecting element according to the present invention, the semiconductor light detecting element can be obtained as one in which the irregular asperity is formed at least in the regions opposed to the pn junction in the first principal surface and in the second principal surface. In this semiconductor light detecting element, as described above, the light incident into the semiconductor light detecting element has the long travel distance and the distance of absorption of light also becomes long, so as to improve the spectral sensitivity characteristic in the near-infrared wavelength band. The accumulation layer formed on the second principal surface side of the silicon substrate can reduce dark current and improve the light detection sensitivity of the semiconductor light detecting element. Since the present embodiment comprises the thermal treatment of the silicon substrate after the step of forming the irregular asperity, the crystallinity of the silicon substrate recovers, so as to prevent the problem such as increase in dark current.

The manufacturing method for the semiconductor light detecting element according to the present invention may be configured as follows: the step of preparing the silicon substrate comprises preparing a silicon substrate in which a semiconductor region of the first conductivity type having an impurity concentration higher than that of the silicon substrate is further formed on the first principal surface side, as the silicon substrate; the manufacturing method further comprises a step of forming an electrode electrically connected to the semiconductor region of the first conductivity type and an electrode electrically connected to the semiconductor region of the second conductivity type, after the step of thermally treating the silicon substrate. In this case, the electrodes are prevented from melting during the step of the thermal treatment even if the electrodes are made of a material having a relatively low melting point. For this reason, the electrodes can be appropriately formed without being affected by the thermal treatment.

The step of forming the irregular asperity may be performed after the step of forming the accumulation layer. In this case, the accumulation layer can be formed in substantially uniform depth. It also enables simultaneous execution of the thermal treatment for recovery and recrystallization of crystal defects caused in the step of forming the irregular asperity and the thermal treatment carried out after the step of forming the accumulation layer, for activation of impurities introduced into the crystal and recovery of crystallinity.

The thickness of the accumulation layer may be made larger than a height difference of the irregular asperity. In this case, the accumulation layer remains even if the irregular asperity is formed by irradiation with the pulsed laser beam, after the step of forming the accumulation layer. For this reason, the aforementioned operational effect by the accumulation layer can be ensured.

The step of forming the irregular asperity may comprise applying a picosecond to femtosecond pulsed laser beam as the pulsed laser beam. In this case, the irregular asperity can be appropriately and readily formed.

### Advantageous Effect of Invention

The present invention permits provision of the semiconductor light detecting element using silicon and having the sufficient spectral sensitivity characteristic in the near-infrared wavelength band and the manufacturing method for the semiconductor light detecting element.

### Brief Description of Drawings

Fig. 1 is a drawing for explaining a manufacturing method for a photodiode according to an embodiment of the present invention.
Fig. 2 is a drawing for explaining the manufacturing method for the photodiode according to the embodiment.
Fig. 3 is a drawing for explaining the manufacturing method for the photodiode according to the embodiment.
Fig. 4 is a drawing for explaining the manufacturing method for the photodiode according to the embodiment.
Fig. 5 is a drawing for explaining the manufacturing method for the photodiode according to the embodiment.
Fig. 6 is a drawing for explaining the manufacturing method for the photodiode according to the embodiment.
Fig. 7 is a drawing for explaining the manufacturing method for the photodiode according to the embodiment.
Fig. 8 is a drawing for explaining the manufacturing method for the photodiode according to the embodiment.
Fig. 9 is a drawing for explaining the manufacturing method for the photodiode according to the embodiment.
Fig. 10 is a drawing for explaining the manufacturing method for the photodiode according to the embodiment.
Fig. 11 is a drawing for explaining the manufacturing method for the photodiode according to the embodiment.
Fig. 12 is a drawing showing a configuration of the photodiode according to the embodiment.

### Description of Embodiments

The preferred embodiments of the present invention will be described below in detail with reference to the accompanying drawings. In the description, the same elements or elements with the same functionality will be denoted by the same reference signs, without redundant description.

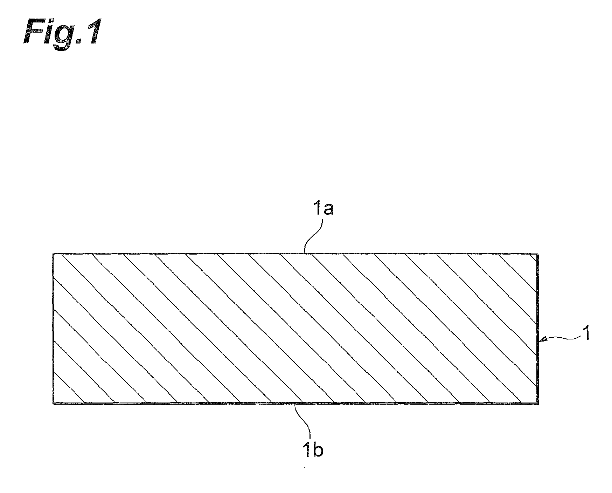

First, a manufacturing method for a photodiode according to an embodiment of the present invention will be described with reference to Figs. 1 to 10. Figs. 1 to 10 are drawings for explaining the manufacturing method for the photodiode according to the present embodiment.

First, prepared is an n⁻ type semiconductor substrate 1 comprised of silicon (Si) crystal and having a first principal surface 1a and a second principal surface 1b opposed to each other (cf. Fig. 1). The n⁻ type semiconductor substrate 1 has the thickness of about 300 µm and the electric resistivity of about 1 kΩ·cm. In the present embodiment, "high impurity concentration" refers, for example, to an impurity concentration of not less than about 1×10¹⁷ cm⁻³ and will be denoted by "+" attached to conductivity type. "Low impurity concentration" refers to an impurity concentration of not more than about 1×10¹⁵ cm⁻³ and will be denoted by "-" attached to conductivity type. An n-type impurity is antimony (Sb) or arsenic (As), and a p-type impurity is boron (B) or the like.

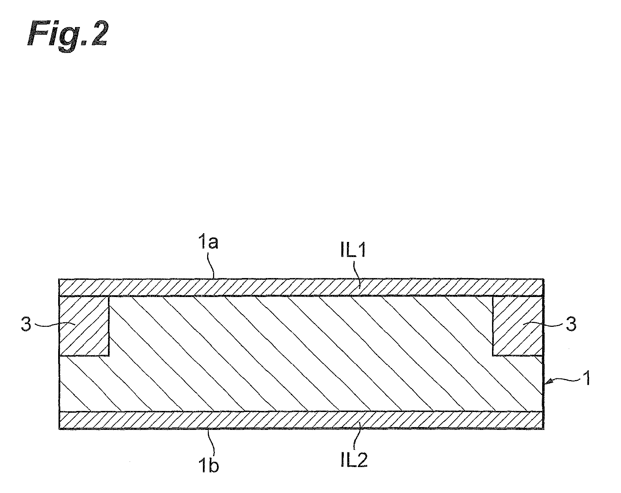

Next, insulating layers IL1, IL2 are formed on the first principal surface 1a and on the second principal surface 1b of the n⁻ type semiconductor substrate 1 (cf. Fig. 2). The insulating layers IL1, IL2 are comprised of SiO₂ and are formed by thermal oxidation of the n⁻ type semiconductor substrate 1. The insulating layers IL1, IL2 have the thickness of, for example, about 0.1 µm.

Next, an n⁺ type semiconductor region 3 is formed on the first principal surface 1a side of the n⁻ type semiconductor substrate 1 (cf. Fig. 2). The n⁺ type semiconductor region 3 is formed by diffusing an n-type impurity from the first principal surface 1a side in the n⁻ type semiconductor substrate 1 so that its concentration becomes higher than that of the n⁻ type semiconductor substrate 1, using another mask opening in its peripheral region. The n⁺ type semiconductor region 3 has the thickness of, for example, about 1.5 µm and the sheet resistance of, for example, 12 Ω/sq.

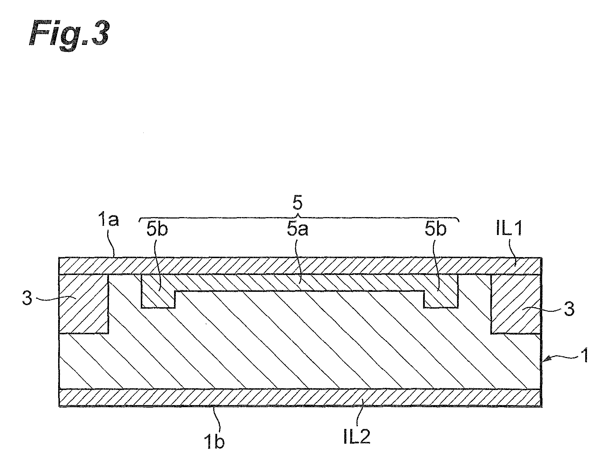

Next, a p⁺ type semiconductor region 5 is formed on the first principal surface 1a side of the n⁻ type semiconductor substrate 1 (cf. Fig. 3). The p⁺ type semiconductor region 5 is formed by diffusing a p-type impurity in a high concentration from the first principal surface 1a side in the n⁻ type semiconductor substrate 1, using a mask opening in its central region. The p⁺ type semiconductor region 5 is formed so as to be surrounded by the n⁺ type semiconductor region 3. The p⁺ type semiconductor region 5 is formed so as to have a first portion 5a located in its central region and having a first thickness, and a second portion 5b located around the central region and having a second thickness larger than the first thickness. The thickness of the first portion 5a of the p⁺ type semiconductor region 5 is, for example, about 2 to 3 µm and the thickness of the second portion 5b of the p⁺ type semiconductor region 5, for example, about 3 µm. The p⁺ type semiconductor region 5 has the sheet resistance of, e.g., 44 Ω/sq.

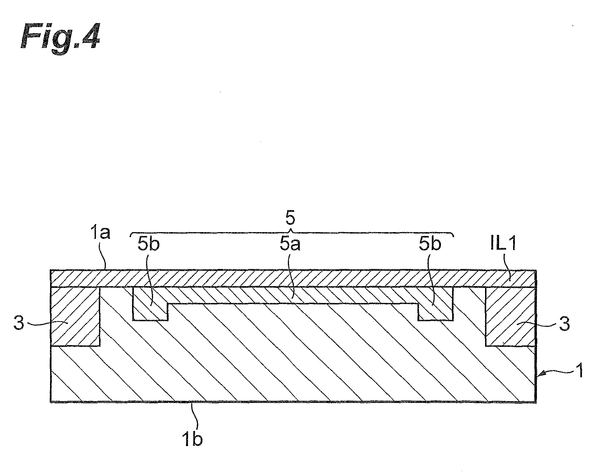

Next, the whole n⁻ type semiconductor substrate 1 is thinned from the second principal surface 1b side so that the thickness of the n⁻ type semiconductor substrate 1 becomes a desired thickness (cf. Fig. 4). This process results in removing the insulating layer IL2 formed on the second principal surface 1b of the n⁻ type semiconductor substrate 1 and thereby exposing the n⁻ type semiconductor substrate 1. The surface exposed by the thinning is also called the second principal surface 1b herein. The desired thickness is, for example, about 100 µm. The thinning of the n⁻ type semiconductor substrate 1 can be implemented by polishing the second principal surface 1b side of the n⁻ type semiconductor substrate 1. The thinning of the n⁻ type semiconductor substrate 1 is not limited to the thinning of the whole n⁻ type semiconductor substrate 1. For example, a portion in the n⁻ type semiconductor substrate 1 corresponding to the p⁺ type semiconductor region 5 may be thinned from the second principal surface 1b side while leaving the surrounding region around the thinned portion. The partial thinning is implemented by anisotropic etching, for example, by alkali etching with a potassium hydroxide solution or TMAH (tetramethylammonium hydroxide solution).

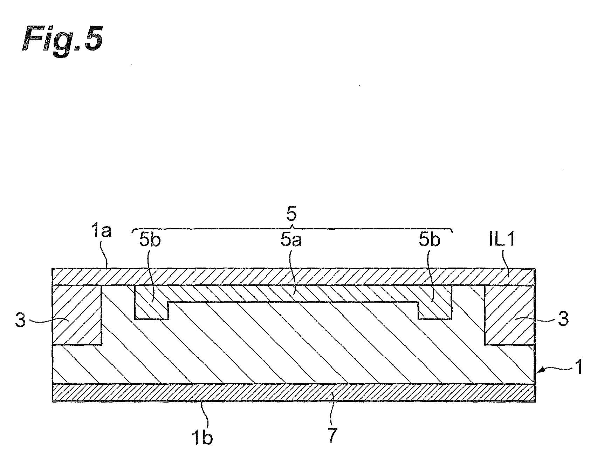

Next, an accumulation layer 7 is formed on the second principal surface 1b side of the n⁻ type semiconductor substrate 1 (cf. Fig. 5). The accumulation layer 7 herein is formed by ion implantation or diffusion of an n-type impurity from the second principal surface 1b side in the n⁻ type semiconductor substrate 1 so that its impurity concentration becomes higher than that of the n⁻ type semiconductor substrate 1. The thickness of the accumulation layer 7 is, for example, about 1 µm. Then the n⁻ type semiconductor substrate 1 is thermally treated to activate the accumulation layer 7. The thermal treatment is carried out, for example, in the temperature range of about 900 to 1000°C in an atmosphere such as N₂ gas, for about 0.5 to 3 hours.

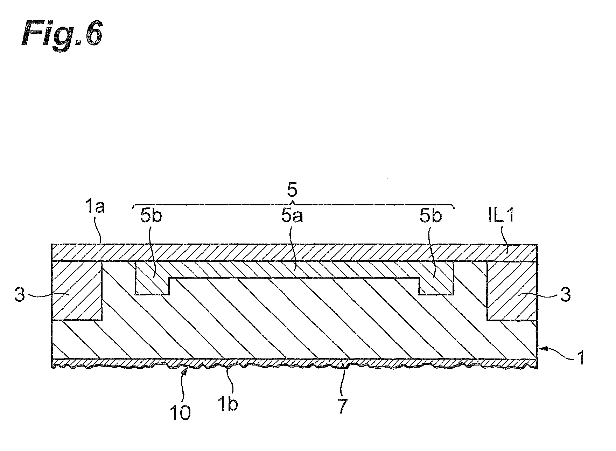

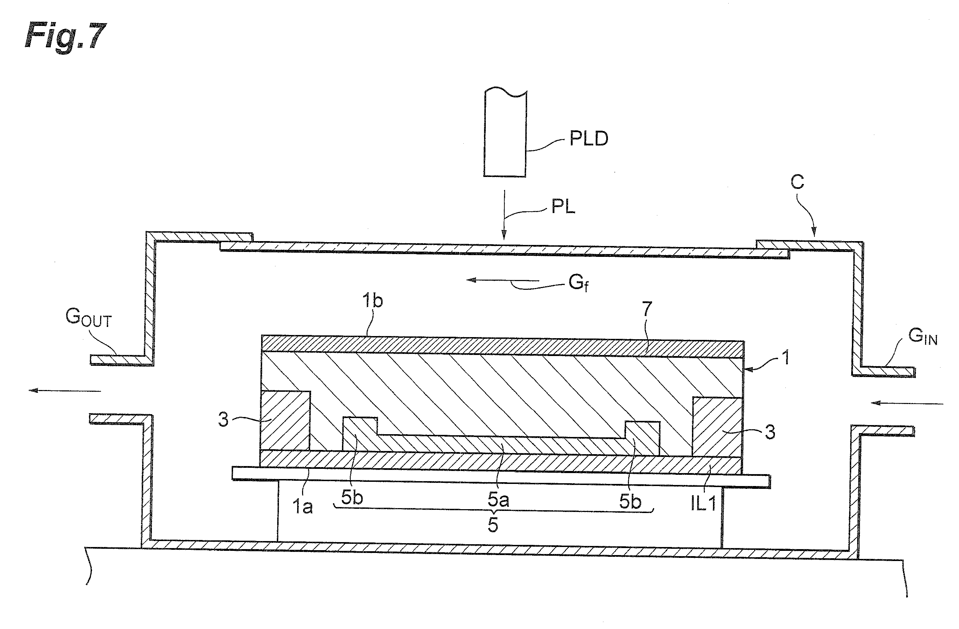

Next, an irregular asperity 10 is formed by irradiating the second principal surface 1b of the n⁻ type semiconductor substrate 1 with a pulsed laser beam PL (cf. Fig. 6). In this process, as shown in Fig. 7, the n⁻ type semiconductor substrate 1 is placed in a chamber C, and the n⁻ type semiconductor substrate 1 is irradiated with the pulsed laser beam PL emitted from a pulse laser generating device PLD located outside the chamber C. The chamber C has a gas inlet port G_{IN} and a gas outlet port G_{OUT}. An inert gas (e.g., nitrogen gas, argon gas, or the like) is introduced through the gas inlet port G_{IN} and discharged through the gas outlet port G_{OUT}, thereby forming an inert gas flow G_{f} in the chamber C. The inert gas flow G_{f} discharges dust and others produced during the irradiation with the pulsed laser beam PL, to the outside of the chamber C, so as to prevent processing debris, dust, etc. from attaching to the n⁻ type semiconductor substrate 1.

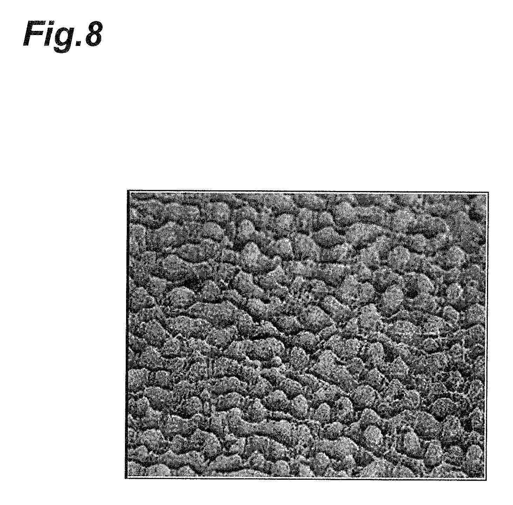

The present embodiment employs a picosecond to femtosecond pulse laser generating device as the pulse laser generating device PLD to irradiate the entire surface of the second principal surface 1b with a picosecond to femtosecond pulsed laser beam. The second principal surface 1b is roughened by the picosecond to femtosecond pulsed laser beam, whereby the irregular asperity 10 is formed throughout the entire surface of the second principal surface 1b, as shown in Fig. 8. The irregular asperity 10 has faces intersecting with a direction perpendicular to the first principal surface 1a. The height difference of the asperity 10 is, for example, about 0.5 to 10 µm and the spacing of projections in the asperity 10 is about 0.5 to 10 µm. The picosecond to femtosecond pulsed laser beam has the pulse duration of, e.g., about 50 fs-2 ps, the intensity of, e.g., about 4 to 16 GW, and the pulse energy of, e.g., about 200 to 800 µJ/pulse. More generally, the peak intensity is 3×10¹¹ to 2.5×10¹³ (W/cm²), and the fluence about 0.1 to 1.3 (J/cm²). Fig. 8 is an SEM image obtained by observation of the irregular asperity 10 formed in the second principal surface 1b.

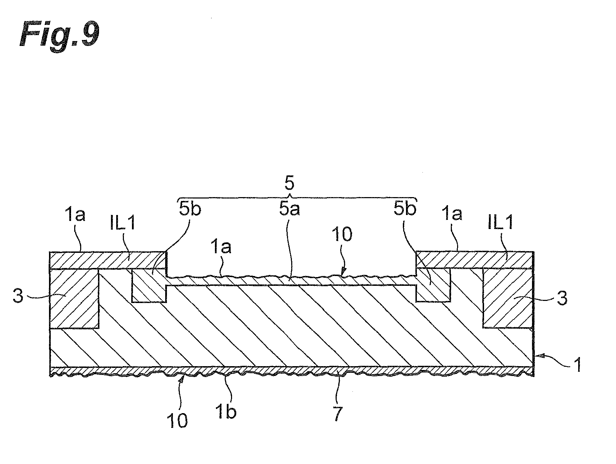

Next, the first principal surface 1a of the p⁺ type semiconductor region 5 is irradiated with the pulsed laser beam PL to form the irregular asperity 10 (cf. Fig. 9). In this process, a region of the insulating layer IL1 corresponding to the first portion 5a of the p⁺ type semiconductor region 5 is irradiated with the pulsed laser beam. This process results in removing the insulating layer IL1 from the region corresponding to the first portion 5a of the p⁺ type semiconductor region 5 and forming the irregular asperity 10 in the exposed first principal surface 1a of the n⁻ type semiconductor substrate 1 (first portion 5a of the p⁺ type semiconductor region 5). The irradiation of the first principal surface 1a (insulating layer IL 1) with the pulsed laser beam is carried out in the same manner as the aforementioned irradiation of the second principal surface 1b with the pulsed laser beam PL. The irregular asperity 10 is not formed in the second portion 5b of the p⁺ type semiconductor region 5.

Next, the n⁻ type semiconductor substrate 1 is thermally treated (or annealed). In this process, the n⁻ type semiconductor substrate 1 is heated in the temperature range of about 800 to 1000°C in an atmosphere such as N₂ gas, for about 0.5 to 1 hour.

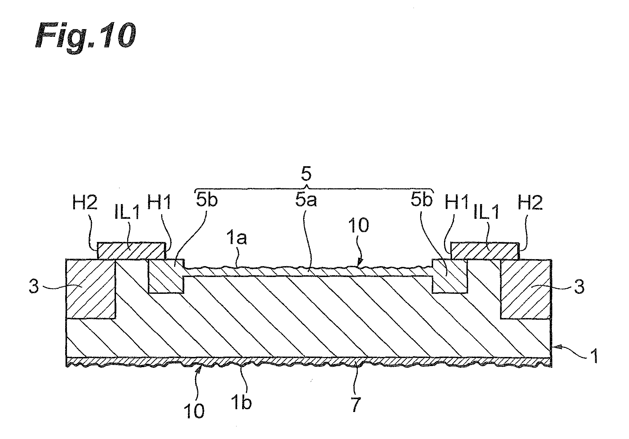

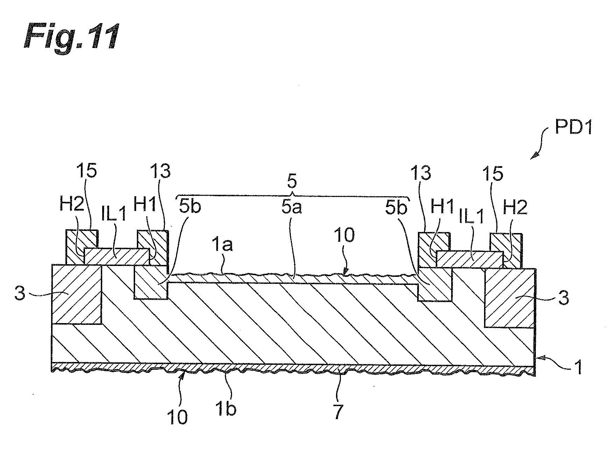

Next, a contact hole H1 is formed in the insulating layer 7 located above the second portion 5b of the p⁺ type semiconductor region 3, and a contact hole H2 is formed in the insulating layer 7 located above the n⁺ type semiconductor region 5 (cf. Fig. 10). Then electrodes 13, 15 are formed (cf. Fig. 11). The electrode 13 is formed in the contact hole H1 and the electrode 15 is formed in the contact hole H2. Each of the electrodes 13, 15 is comprised of aluminum (A1) or the like and the thickness thereof is, for example, about 1 µm. This completes a photodiode PD1.

The photodiode PD1, as shown in Fig. 11, is provided with the n⁻ type semiconductor substrate 1. The p⁺ type semiconductor region 5 (first portion 5a and second portion 5b) and the n⁺ type semiconductor region 3 are formed on the first principal surface 1a side of the n⁻ type semiconductor substrate 1, and a pn junction is formed between the n⁻ type semiconductor substrate 1 and the p⁺ type semiconductor region 5. Namely, the n⁻ type semiconductor substrate 1 has the pn junction formed of a semiconductor region of a first conductivity type and a semiconductor region of a second conductivity type. The n⁺ type semiconductor region 3 functions as a guard ring.

The electrode 13 is in electrical contact and connection with the p⁺ type semiconductor region 5 (second portion 5b) through the contact hole H1. The electrode 15 is in electrical contact and connection with the n⁺ type semiconductor region 3 through the contact hole H2.

The irregular asperity 10 is formed in the second principal surface 1b of the n⁻ type semiconductor substrate 1. The accumulation layer 7 is formed on the second principal surface 1b side of the n⁻ type semiconductor substrate 1. The second principal surface 1b is optically exposed. That the second principal surface 1b is optically exposed encompasses not only a configuration wherein the second principal surface 1b is in contact with the ambient gas such as air, but also a configuration wherein an optically transparent film is formed on the second principal surface 1b.

On the first principal surface 1a side of the n⁻ type semiconductor substrate 1, the irregular asperity 10 is formed in the exposed surface of the first portion 5a of the p⁺ type semiconductor region 5. Therefore, the irregular asperity 10 is formed in the regions corresponding to the pn junction in the first principal surface 1a and in the second principal surface 1b of the n⁻ type semiconductor substrate 1. The region where the irregular asperity 10 is formed in the first principal surface 1a of the n⁻ type semiconductor substrate 1 is optically exposed. That the first principal surface 1a is optically exposed encompasses not only a configuration wherein the first principal surface 1a is in contact with the ambient gas such as air, but also a configuration wherein an optically transparent film is formed on the first principal surface 1a.

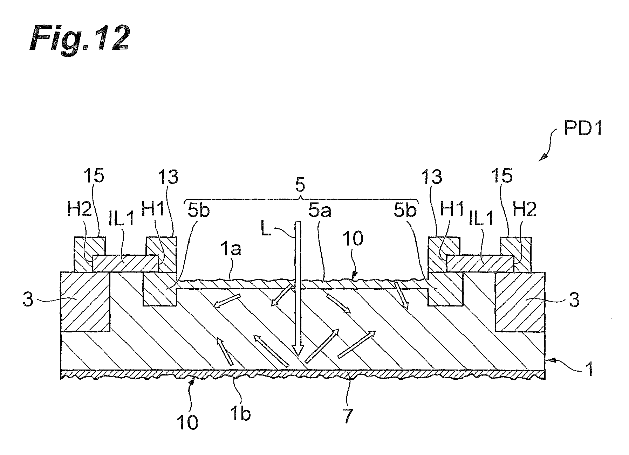

In the photodiode PD1, the irregular asperity 10 is formed in the first principal surface 1a and in the second principal surface 1b. For this reason, light L incident into the photodiode PD1 is reflected, scattered, or diffused by the irregular asperity 10, as shown in Fig. 12, to travel through a long distance in the n⁻ type semiconductor substrate 1.

Usually, Si has the refractive index n=3.5 and air the refractive index n=1.0. When light is incident into a photodiode from a direction normal to a light incident surface thereof, light remaining unabsorbed in the photodiode (silicon substrate) is separated in a light component reflected on the back to the light incident surface and a light component transmitted by the photodiode. The light transmitted by the photodiode does not contribute to the sensitivity of the photodiode. The light component reflected on the back to the light incident surface becomes a photocurrent if absorbed in the photodiode. The light component still remaining unabsorbed is reflected or transmitted on the light incident surface as the light component reaching the back to the light incident surface was.

In the photodiode PD1, when light L is incident from a normal direction to the light incident surface (first principal surface 1a) and then arrives at the irregular asperity 10 formed in the second principal surface 1b, light components arriving at angles of not less than 15.6° to the direction of emergence from the asperity 10 are totally reflected by the irregular asperity 10. Since the asperity 10 is irregularly formed, it has various angles relative to the direction of emergence and thus the totally reflected light components are diffused into various directions. For this reason, the totally reflected light components include light components absorbed inside the n⁻ type semiconductor substrate 1 and light components arriving at the first principal surface 1a and side faces.

Since light components arriving at the region of the first principal surface 1a where the irregular asperity 10 is formed travel in various directions because of the diffusion on the irregular asperity 10 formed in the second principal surface 1b, they are extremely highly likely to be totally reflected. Since the asperity 10 formed in the first principal surface 1a is also irregularly formed, it has various angles relative to the direction of emergence and thus the totally reflected light components are again diffused into various directions. Light components arriving at the regions without the irregular asperity 10 in the first principal surface 1a and at the side faces travel in various directions because of the diffusion on the irregular asperity 10. For this reason, the light components arriving at the first principal surface 1a and the side faces are also highly likely to be totally reflected on the first principal surface 1a and the side faces. The light components totally reflected on the first principal surface 1a and the side faces are repeatedly totally reflected on different surfaces to increase their travel distance. In this manner, the light L incident into the photodiode PD1 travels through the long distance inside the n⁻ type semiconductor substrate 1 to be absorbed in the n⁻ type semiconductor substrate 1 and detected as photocurrent.

In this way, the light L incident into the photodiode PD1 mostly travels through the increased travel distance without passing through the photodiode PD1, so as to be absorbed in the n⁻ type semiconductor substrate 1. Therefore, the photodiode PD1 improves its spectral sensitivity characteristic in the near-infrared wavelength band.

If a regular asperity is formed in the second principal surface 1b, the light components arriving at the first principal surface 1a and the side faces are those diffused by the asperity but they travel in uniform directions. For this reason, the light components arriving at the first principal surface 1a and the side faces are less likely to be totally reflected on the first principal surface 1a and the side faces. Therefore, more light components travel through the first principal surface 1a and the side faces and further through the second principal surface 1b, so as to decrease the travel distance of the light incident into the photodiode. As a result, it becomes difficult to improve the spectral sensitivity characteristic in the near-infrared wavelength band. Similarly, if a regular asperity is formed in the first principal surface 1a, it also becomes difficult to improve the spectral sensitivity characteristic in the near-infrared wavelength band.

In the photodiode PD1, the accumulation layer 7 is formed on the second principal surface 1b side of the n⁻ type semiconductor substrate 1. This induces recombination of unnecessary carriers generated on the second principal surface 1b side, so as to reduce dark current. The accumulation layer 7 prevents carriers generated near the second principal surface 1b from being trapped in the second principal surface 1b. For this reason, the generated carriers efficiently migrate to the pn junction portion, so as to further improve the light detection sensitivity of the photodiode PD1.

In the present embodiment the irregular asperity 10 is formed after formation of the accumulation layer 7. This allows the accumulation layer 7 to be formed in substantially uniform depth. It also allows simultaneous execution of the thermal treatment for recovery and recrystallization of crystal defects produced in the step of forming the irregular asperity 10, and the thermal treatment carried out after the step of forming the accumulation layer 10, for activation of impurities introduced into the crystal by ion implantation or diffusion, and recovery of crystallinity.

In the present embodiment, the n⁻ type semiconductor substrate 1 is thermally treated after formation of the irregular asperity 10. This achieves recovery of crystallinity of the n⁻ type semiconductor substrate 1 and prevention of the problem such as increase in dark current.

In the present embodiment, the electrodes 13, 15 are formed after the thermal treatment of the n⁻ type semiconductor substrate 1. This prevents the electrodes 13, 15 from melting during the thermal treatment even if the electrodes 13, 15 are made of a metal having a relatively low melting point. As a consequence, the electrodes 13, 15 can be properly formed without being affected by the thermal treatment.

In the present embodiment, the irregular asperity 10 is formed by irradiation with the picosecond to femtosecond pulsed laser beam. This allows appropriate and easy formation of the irregular asperity 10.

In the present embodiment, the n⁻ type semiconductor substrate 1 is thinned from the second principal surface 1b side. This allows the photodiode to be formed with respective light incident surfaces on the first principal surface 1a side and on the second principal surface 1b side of the n⁻ type semiconductor substrate 1. Namely, the photodiode PD1 can be used not only as a front-illuminated type photodiode but also as a back-thinned type photodiode.

Incidentally, when a photodiode is formed by setting a semiconductor substrate of silicon thick (e.g., about several mm), it is possible to realize a semiconductor light detecting element having a spectral sensitivity characteristic in the near-infrared wavelength band. The photodiode requires application of a bias voltage for depletion. For this reason, an extremely high bias voltage needs to be applied in the case where the thickness of the semiconductor substrate is set large. The increase in thickness of the semiconductor substrate also leads to increase in dark current.

In the photodiode PD1 of the present embodiment, however, the travel distance of the light incident into the photodiode PD1 is lengthened because the irregular asperity 10 is formed in the first principal surface 1a and in the second principal surface 1b, as described above. For this reason, it is feasible to realize the photodiode having the sufficient spectral sensitivity characteristic in the near-infrared wavelength band, without increase in thickness of the semiconductor substrate (n⁻ type semiconductor substrate 1). Therefore, the foregoing photodiode PD1 can achieve the good spectral sensitivity characteristic with application of a lower bias voltage than the photodiode having the spectral sensitivity characteristic in the near-infrared wavelength band based on the increase in the thickness of the semiconductor substrate. The increase in dark current is suppressed, so as to improve the detection accuracy of the photodiode PD1. The response speed of the photodiode PD1 improves because of the small thickness of the n⁻ type semiconductor substrate 1.

The above described the preferred embodiment of the present invention, but it should be noted that the present invention is not always limited to the above-described embodiment but can be modified in many ways without departing from the scope and spirit of the invention.

In the present embodiment the pulsed laser beam is applied across the entire surface of the second principal surface 1b to form the irregular asperity 10, but the present invention does not always have to be limited to this. For example, the irregular asperity 10 may be formed by irradiating only the region opposed to the p⁺ type semiconductor region 5 in the second principal surface 1b of the n⁻ type semiconductor substrate 1, with the pulsed laser beam.

In the present embodiment the electrode 15 is in electrical contact and connection with the n⁺ type semiconductor region 3 formed on the first principal surface 1a side of the n⁻ type semiconductor substrate 1, but the present invention does not always have to be limited to this. For example, the electrode 15 may be in electrical contact and connection with the accumulation layer 7 formed on the second principal surface 1b side of the n⁻ type semiconductor substrate 1. In this case, the electrode 15 is formed preferably outside the region opposed to the p⁺ type semiconductor region 5 in the second principal surface 1b of the n⁻ type semiconductor substrate 1. The reason for it is as follows: if the electrode 15 is formed in the region opposed to the p⁺ type semiconductor region 5 in the second principal surface 1b of the n⁻ type semiconductor substrate 1, the irregular asperity 10 formed in the second principal surface 1b is closed by the electrode 15, so as to bring about an event of reduction in spectral sensitivity in the near-infrared wavelength band.

The conductivity types of p-type and n-type in the photodiode PD1 of the present embodiment may be interchanged so as to be opposite to those described above.

In the present embodiment the irregular asperity 10 is formed after formation of the accumulation layer 7, but the present invention does not always have to be limited to this. The step of forming the irregular asperity 10 may be arranged in such a manner that the accumulation layer 7 is formed after formation of the irregular asperity 10.

The present invention, without having to be limited to the photodiode described by way of illustration as the above embodiment, can be applied to semiconductor light detecting elements with a silicon substrate having a pn junction, such as photodiode arrays, avalanche photodiodes, avalanche photodiode arrays, and bipolar or CMOS photo ICs (integrated circuits of a light receiving section and a signal processing circuit for light receiving section).

### Industrial Applicability

The present invention is applicable to the semiconductor light detecting elements such as photodiodes.

### List of Reference Signs

1 ... n⁻ type semiconductor substrate; 1a ... first principal surface; 1b ... second principal surface; 3 ... n⁺ type semiconductor region; 5 ... P⁺ type semiconductor region; 7 ... accumulation layer; 10 ... irregular asperity; 13, 15 ... electrodes; PL ... pulsed laser beam; PD1 ...photodiode..

## Claims

1. A semiconductor light detecting element comprising:
a silicon substrate having a pn junction formed of a semiconductor region of a first conductivity type and a semiconductor region of a second conductivity type,
wherein for the silicon substrate, an accumulation layer of the first conductivity type is formed on one principal surface side of the silicon substrate and an irregular asperity is formed at least in regions opposed to the pn junction in the one principal surface and in a principal surface opposed to the one principal surface, and
wherein the regions opposed to the pn junction in the one principal surface of the silicon substrate and in the principal surface thereof opposed to the one principal surface are optically exposed.

2. A semiconductor light detecting element comprising:
a silicon substrate comprised of a semiconductor of a first conductivity type, having a first principal surface and a second principal surface opposed to each other, and having a semiconductor region of a second conductivity type formed on the first principal surface side,
wherein for the silicon substrate, an accumulation layer of the first conductivity type having an impurity concentration higher than that of the silicon substrate is formed on the second principal surface side and an irregular asperity is formed at least in regions opposed to the semiconductor region of the second conductivity type in the first principal surface and in the second principal surface, and
wherein the regions opposed to the semiconductor region of the second conductivity type in the first principal surface and in the second principal surface of the silicon substrate are optically exposed.

3. The semiconductor light detecting element according to claim 1 or 2,
wherein a thickness of the accumulation layer is larger than a height difference of the irregular asperity.

4. A method for manufacturing a semiconductor light detecting element, comprising:
a step of preparing a silicon substrate having a pn junction formed of a semiconductor region of a first conductivity type and a semiconductor region of a second conductivity type;
a step of forming an accumulation layer of the first conductivity type on one principal surface side of the silicon substrate;
a step of irradiating at least regions opposed to the pn junction in the one principal surface of the silicon substrate and in a principal surface thereof opposed to the one principal surface, with a pulsed laser beam to form an irregular asperity; and
a step of thermally treating the silicon substrate in which the irregular asperity is formed.

5. The manufacturing method for the semiconductor light detecting element according to claim 4,
wherein the step of preparing the silicon substrate comprises preparing a silicon substrate in which a semiconductor region of the first conductivity type having an impurity concentration higher than that of the silicon substrate is further formed on the principal surface side opposed to the one principal surface, as the silicon substrate,
the manufacturing method further comprising a step of forming an electrode electrically connected to the semiconductor region of the first conductivity type and an electrode electrically connected to the pn junction, after the step of thermally treating the silicon substrate.

6. A method for manufacturing a semiconductor light detecting element, comprising:
a step of preparing a silicon substrate comprised of a semiconductor of a first conductivity type, having a first principal surface and a second principal surface opposed to each other, and having a semiconductor region of a second conductivity type formed on the first principal surface side;
a step of forming an accumulation layer of the first conductivity type having an impurity concentration higher than that of the silicon substrate, on the second principal surface side of the silicon substrate;
a step of irradiating at least regions opposed to the semiconductor region of the second conductivity type in the second principal surface of the silicon substrate, with a pulsed laser beam to form an irregular asperity; and
a step of thermally treating the silicon substrate, after the step of forming the irregular asperity.

7. The manufacturing method for the semiconductor light detecting element according to claim 6,
wherein the step of preparing the silicon substrate comprises preparing a silicon substrate in which a semiconductor region of the first conductivity type having an impurity concentration higher than that of the silicon substrate is further formed on the first principal surface side, as the silicon substrate,
the manufacturing method further comprising a step of forming an electrode electrically connected to the semiconductor region of the first conductivity type and an electrode electrically connected to the semiconductor region of the second conductivity type, after the step of thermally treating the silicon substrate.

8. The manufacturing method for the semiconductor light detecting element according to claim 4 or 6,
wherein the step of forming the irregular asperity is carried out after the step of forming the accumulation layer.

9. The manufacturing method for the semiconductor light detecting element according to claim 8,
wherein a thickness of the accumulation layer is made larger than a height difference of the irregular asperity.

10. The manufacturing method for the semiconductor light detecting element according to any one of claims 4 to 9,
wherein the step of forming the irregular asperity comprises applying a picosecond to femtosecond pulsed laser beam as the pulsed laser beam.
